# EUROPEAN PATENT APPLICATION

(11) **EP 4 481 742 A1**
(43) Date of publication of application: **25.12.2024**
(21) Application number: 24183155.1
(22) Date of filing: 19.06.2024
(51) Int. Cl.: G11C 5/04, G11C 7/10, H01L 23/00, G06F 13/38

(54) **SYSTEMS AND METHODS FOR SEMICONDUCTOR DEVICES WITH DIE-TO-DIE INTERFACES**

(30) Priority: 23.06.2023 US 202363510066 P; 28.09.2023 US 202318476868
(71) Applicant: Avago Technologies International Sales Pte. Limited, Singapore 768923 (SG)
(72) Inventor: Tufano, A. J., Fort Collins, CO 80528 (US)
(74) Representative: Dilg, Haeusler, Schindelmann Patentanwaltsgesellschaft mbH

(57) **Abstract**

The subject technology is directed to systems and methods for semiconductor devices with die-to-die interfaces. In an embodiment, the subject technology provides an apparatus that includes a first circuit (106, 206, 306) comprising a first interface (108, 308). The apparatus further includes a first memory device (118, 210, 318) coupled to the first circuit (106, 206, 306) through a second circuit (110, 208, 310). The second circuit (110, 208, 310) includes a second interface coupled to the first memory device (118, 210, 318) and a third interface (120, 320) coupled to the first circuit (106, 206, 306). The one or more interfaces of the apparatus are optimized to support a high data rate, breaking the design constraints between the circuit and the associated memory devices. There are other embodiments as well.

## Description

### CROSS REFERENCE TO RELATED APPLICATIONS

This application is a non-provisional application of U.S. Patent Application No. 63/510,066, filed June 23, 2023, by Tufano and titled, "Method for Bridging Die to Die Chiplet Interfaces to High Bandwidth Memory", the entire teachings of which is incorporated herein by reference in its entirety for all purposes.

### FIELD OF INVENTION

The subject technology is directed to systems and methods for semiconductor devices with die-to-die interfaces.

### BACKGROUND OF THE INVENTION

Integrated circuit (IC) design in the arena of High-Performance Computer (HPC) and Artificial Intelligence (AI) heavily relies on the efficiency and performance of memory systems. With modem computational models demanding rapid data access and expansive storage, memory systems like High Bandwidth Memory (HBM) have emerged as important components in Systems on a Chip (SoC). For example, HBM refers to a memory that provides a high-speed computer memory interface for 3D-stacked synchronous dynamic random-access memory (SDRAM), and it is standardized stacked memory technology that provides very wide channels for data, both within the stack and between the memory and logic. A crucial challenge in integrating such memory systems is the spatial limitation imposed by the need for short, electrically efficient connections between the HBM and the SoC. Due to the spatial limitation, the HBM needs to be positioned adjacently to the SoC edge. Consequently, the periphery of the SoC becomes a restricting factor, determining the number of HBMs that can be integrated within the System in Package (SiP). An expansion in the size of the SoC to accommodate more HBM not only escalates the cost but also confronts manufacturing constraints.

Over the past, various systems and methods have been proposed, but they are inadequate for the reasons explained below. New and improved integration systems and methods for semiconductor devices are desired.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Figure 1 is a simplified diagram illustrating a semiconductor device characterized by an integration scheme according to embodiments of the subject technology.
Figure 2 is a simplified diagram illustrating a cross-section view of a semiconductor device characterized by an integration scheme according to embodiments of the subject technology.
Figure 3 is a simplified diagram illustrating a semiconductor device characterized by an integration scheme according to embodiments of the subject technology.
Figure 4 is a simplified diagram illustrating a semiconductor device characterized by an integration scheme according to embodiments of the subject technology.

### DETAILED DESCRIPTION OF THE INVENTION

The subject technology is directed to systems and methods for semiconductor devices with die-to-die interfaces. In an embodiment, the subject technology provides an apparatus that includes a first circuit comprising a first interface. The apparatus further includes a first memory device coupled to the first circuit through a second circuit. The second circuit includes a second interface coupled to the first memory device and a third interface coupled to the first circuit. The one or more interfaces of the apparatus are optimized to support a high data rate, breaking the design constraints between the circuit and the associated memory devices. There are other embodiments as well.

Some approaches for implementing semiconductor integration involve connecting one or more HBM to an SoC through interconnects in the interposer. For instance, SoC or system-on-a-chip refers to an integrated circuit that combines multiple functional components of a computer or other electronic systems onto a single chip. These components can include a central processing unit (CPU), memory interfaces, input/output devices, input/output interfaces, secondary storage interfaces, and/or the like. The HBMs may be configured as discrete memory dies, which connect to the SoC through one or more physical interfaces with routing over interposer. However, the placement of HBMs often grapples with spatial constraints-predominantly dictated by the SoC's configuration and dimension-posing challenges both in terms of design scalability and flexibility. For instance, HBM must be closely aligned to the SoC to ensure the efficacy of data transmission. Additionally, the dimensional attributes of the SoC pose intrinsic limitations on the volume of HBM content that can be incorporated within the system, which results in limited memory bandwidth and capacity, potentially hampering the overall system performance in data-intensive applications. Moreover, various industry standards adopt a rigid integration paradigm-any potential enhancements to the HBM would mandate corresponding modifications to the SoC-which not only restricts design flexibility but also raises concerns over future adaptability.

In various embodiments, the subject technology provides semiconductor devices that break the design constraints between HBM and SoC by incorporating a bridge circuit coupled between SoC and one or more associated HBMs. The interface of the bridge circuit is optimized to support a high data rate as compared to the HBM interface, leading to enhanced bandwidth and increased data processing capacity. This optimized interface provides the flexibility to accommodate extended routing lengths between the SoC and HBM, ensuring the minimization of signal degradation and high-speed data transmission. Moreover, by strategically embedding supporting digital logic tailored for the HBM within the bridge circuit, embodiments of the subject technology realize another layer of operational flexibility. This modular architecture ensures that any changes to the HBM can be confined to the bridge circuit without impact on the SoC, enabling continuity of function and reducing potential design and testing overheads associated with system-wide modifications.

The following description is presented to enable one of ordinary skill in the art to make and use the invention and to incorporate it in the context of particular applications. Various modifications, as well as a variety of uses in different applications will be readily apparent to those skilled in the art, and the general principles defined herein may be applied to a wide range of embodiments. Thus, the subject technology is not intended to be limited to the embodiments presented, but is to be accorded the widest scope consistent with the principles and novel features disclosed herein.

In the following detailed description, numerous specific details are set forth in order to provide a more thorough understanding of the subject technology. However, it will be apparent to one skilled in the art that the subject technology may be practiced without necessarily being limited to these specific details. In other instances, well-known structures and devices are shown in block diagram form, rather than in detail, in order to avoid obscuring the subject technology.

The reader's attention is directed to all papers and documents which are filed concurrently with this specification and which are open to public inspection with this specification, and the contents of all such papers and documents are incorporated herein by reference. All the features disclosed in this specification, (including any accompanying claims, abstract, and drawings) may be replaced by alternative features serving the same, equivalent or similar purpose, unless expressly stated otherwise. Thus, unless expressly stated otherwise, each feature disclosed is one example only of a generic series of equivalent or similar features.

Furthermore, any element in a claim that does not explicitly state "means for" performing a specified function, or "step for" performing a specific function, is not to be interpreted as a "means" or "step" clause as specified in 35 U.S.C. Section 112, Paragraph 6. In particular, the use of "step of' or "act of' in the Claims herein is not intended to invoke the provisions of 35 U.S.C. 112, Paragraph 6.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Similarly, when an element is referred to herein as being "bonded" to another element, it is to be understood that the elements can be directly bonded to the other element (without any intervening elements) or have intervening elements present between the bonded elements. In contrast, when an element is referred to as being "directly bonded" to another element, it should be understood that no intervening elements are present in the "direct" bond between the elements. However, the existence of direct bonding does not exclude other forms of bonding, in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require the selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

One general aspect includes an apparatus comprising a first circuit, which comprises a first interface. The apparatus further comprises a second circuit coupled to the first circuit. The second circuit comprises a second interface and a third interface. The third interface is coupled to the first interface. The apparatus further comprises an interposer coupled to the second circuit. The apparatus further comprises a first memory device coupled to the interposer. The first memory device comprises a fourth interface. The fourth interface is coupled to the second interface. In some embodiments, the second interface is characterized by a first data rate and the third interface is characterized by a second data rate. The second data rate is greater than the first data rate.

Implementations may include one or more of the following features. The apparatus may further comprise a substrate coupled to the interposer. The first circuit may be coupled to the substrate. The interposer may comprise a first interconnect, and the first interface may be coupled to the third interface through the first interconnect. The interposer may comprise a second interconnect, and the second interface may be coupled to the fourth interface through the second interconnect. The second circuit further comprises a controller configured to manage a data flow between the first memory device and the first circuit. The first memory device may further comprise a high-bandwidth memory. A ratio of the second data rate to the first data rate may be greater than 5:1.

According to another embodiment, the subject technology provides an apparatus comprising a substrate and an interposer coupled to the substrate. The apparatus further comprises a first circuit coupled to the interposer. The first circuit comprises a first interface. The apparatus further comprises a second circuit coupled to the interposer. The second circuit comprises a second interface and a third interface, the third interface being coupled to the first interface. The apparatus further comprises a first memory device coupled to the interposer. The first memory device comprises a fourth interface, the fourth interface being coupled to the second interface. In some embodiments, the second interface is characterized by a first data rate, the third interface is characterized by a second data rate, and the second data rate is greater than the first data rate.

Implementations may include one or more of the following features. The interposer may comprise a first interconnect, and the first interface may be coupled to the third interface through the first interconnect. The interposer may comprise a second interconnect, and the second interface may be coupled to the fourth interface through the second interconnect. The second circuit may further comprise a controller configured to manage a data flow between the first memory device and the first circuit. The first memory device may further comprise a high-bandwidth memory. The second interface may comprise a memory interface.

According to yet another embodiment, the subject technology provides an apparatus comprising a substrate and a first circuit coupled to the substrate. The first circuit comprises a first interface. The apparatus further comprises a second circuit coupled to the first circuit. The second circuit comprises a second interface and a third interface. The third interface is coupled to the first interface. The apparatus further comprises a first memory device coupled to the second circuit. The first memory device comprises a fourth interface, the fourth interface being coupled to the second interface. In some embodiments, the second interface is characterized by a first data rate, the third interface is characterized by a second data rate, and the second data rate is greater than the first data rate.

Implementations may include one or more of the following features. The apparatus may further comprise an interposer coupled between the substrate and the second circuit. The apparatus may further comprise a second memory device. The second memory device may be coupled to the second circuit. The second circuit may further comprise a fifth interface, and the second memory device comprises a sixth interface coupled to the fifth interface. The second circuit may comprise a controller configured to manage a data flow between the first memory device and the first circuit. A ratio of the second data rate to the first data rate may be greater than 5:1.

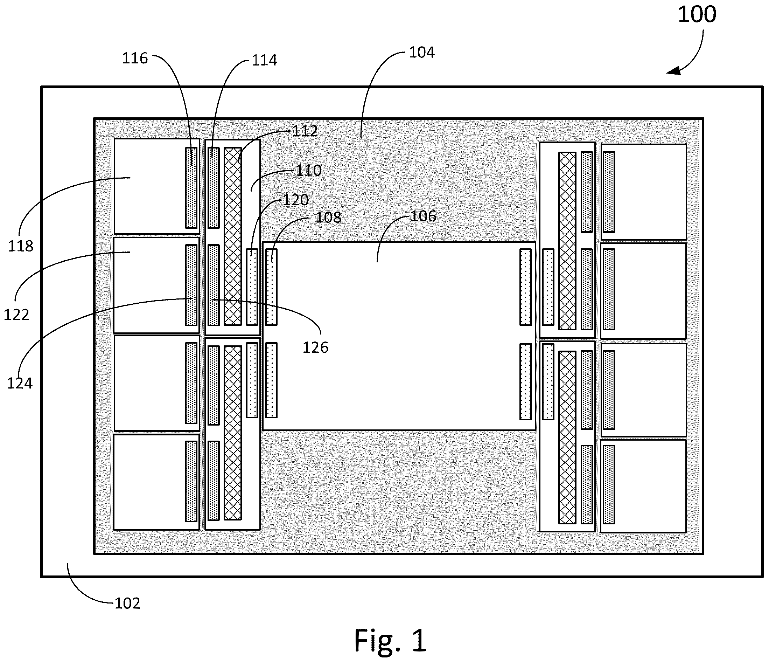

Figure 1 is a simplified diagram illustrating a semiconductor device 100 characterized by an integration scheme according to embodiments of the subject technology. This diagram is merely an example, which should not unduly limit the scope of the claims. One of ordinary skill in the art would recognize many variations, alternatives, and modifications. Semiconductor device 100 as illustrated in Figure 1, includes a circuit 106 (e.g., a first circuit recited in claim 1). As an example, circuit 106 serves as a main compute die configured for various computational tasks, data transactions, and processing activities, which include, without limitation, digital signal processing, image processing, network data routing, machine learning, and/or any application demanding specific computational needs. In various embodiments, circuit 106 may be implemented in a system-on-chip (SoC) arrangement. The term "system-on-a-chip" or "system-on-chip" refers to an integrated circuit that combines multiple functional components of a computer or other electronic systems onto a single chip. For instance, circuit 106 can include an application-specific integrated circuit (ASIC), a central processing unit (CPU), memory interfaces, input/output devices, input/output interfaces, secondary storage interfaces, and/or the like.

In some embodiments, circuit 106 includes an interface 108 (e.g., a first interface recited in claim 1). As an example, the term "interface" may refer to a shared boundary or a point of interaction across which two or more separate components of a computer system communicate, transmitting signals, power, or data. The interface may be a physical interface and/or logic interface based upon various industry standards including, without limitation, Double Data Rate (DDR), High Bandwidth Memory (HBM), Hybrid Memory Cube (HMC), Serial Memory Interface (SMI), Coherent Accelerator Processor Interface (CAPI), and/or the like. For instance, interface 108 includes a die-to-die interface, which may be configured to connect and interact with other components of semiconductor 100. The terms "die" or "semiconductor die" may refer to a piece or segment of semiconductor material (e.g., silicon), which contains integrated circuitry. This integrated circuitry can encompass various electronic components such as transistors, capacitors, resistors, and other microelectronic structures, which together perform specific electronic functions. The term "die-to-die interface" refers to a functional block that provides the data interface between two or more dies. Die-to-die interfaces can be implemented as short channels for connecting two dies inside a package to achieve power efficiency and high bandwidth efficiency. Die-to-die interfaces may include a physical interface and/or a logic interface that provides a seamless connection between the two dies. The die-to-die interface can be implemented using a high-speed SerDes architecture or high-density parallel architecture, which are optimized to support multiple advanced 2D, 2.5D, and 3D packaging technologies.

In various implementations, interface 108 may be configured to support a high data rate. The term "data rate" or "data transfer rate" refers to the speed at which data can be transferred between two or more electronic components. The data rate of a semiconductor die can be measured in gigabits per second (Gbps) or terabits per second (Tbps). The data rate of a semiconductor die may be associated with a variety of factors including, without limitation, the number of pins on the die, the clock speed of the interface, the signal-to-noise ratio, and the type of interface used. For instance, interface 108 is characterized by a data rate greater than 256 Gbps to enhance bandwidth and system throughput for data-intensive applications.

According to some embodiments, semiconductor device 100 may further include a memory device 118 (e.g., a first memory device recited in claim 1). The term "memory device" may refer to an electronic chip or integrated circuit configured to store, retain, and facilitate retrieval of data. In some cases, semiconductor 100 further includes a memory device 122 (e.g., a second memory device recited in the claims). For instance, memory device 118 and/or memory device 122 may include, without limitation, high-bandwidth memory (HBM), Dynamic random-access memory (DRAM), static random-access memory (SRAM), flash memory, phase-change memory (PCM), magnetoresistive rand random-access memory (MRAM), electrically erasable programmable read-only memory (EEPROM), and/or the like. As an example, memory device 118 includes a high-bandwidth memory (HBM). The term "high-bandwidth memory" or "HBM" may refer to a high-speed random-access memory interface designed for use in high-performance applications, such as graphics cards, high-performance computing, machine learning, and/or the like.

Depending on the implementation, memory device 118 may include an interface 116 (e.g., a fourth interface recited in claim 1), which may be configured to connect and interact with other components of semiconductor 100. In some cases, memory device 122 includes an interface 124 (e.g., a sixth interface recited in the claims), which may be configured to be coupled to circuit 110. For instance, circuit 110 further includes an interface 126 (e.g., a fifth interface recited in the claims). Interface 124 may be coupled to interface 126. Interface 116 and/or interface 124 may include, without limitation, Double Data Rate (DDR), High Bandwidth Memory (HBM), Hybrid Memory Cube (HMC), Serial Memory Interface (SMI), Coherent Accelerator Processor Interface (CAPI), and/or the like. As an example, interface 116 includes an HBM interface. The term "HBM interface" may refer to a high-speed memory interface tailored for HBM chips. It facilitates stacked die memory configurations, promising elevated bandwidths and data transfer rates while conserving power.

In various implementations, memory device 118 can be coupled to circuit 106 through circuit 110 (e.g., a second circuit recited in claim 1). Circuit 110 may be configured to bridge the connections between circuit 106 and memory device 118, ensuring smooth and efficient data communication. Its architecture can be tailored to adeptly translate, route, and buffer data transmissions, facilitating synchronous communication between the components. This is important when the involved components, such as circuit 106 and memory device 118, are designed to function based on distinct operational speeds or set industry standards.

As an example, circuit 110 includes an interface 120 (e.g., a third interface recited in claim 1) and an interface 114 (e.g., a second interface recited in claim 1). Interface 120 may be coupled to interface 108 of circuit 106. Interface 114 may be coupled to interface 116 of memory device 118. These interfaces enable bi-directional data transmission and can be equipped with advanced capabilities including, without limitation, error mitigation, signal conditioning, and/or synchronization features. Depending on the implementation, these interfaces may be characterized by different data rates. For instance, interface 116 and interface 114 may be characterized by a first data rate; interface 108 and interface 120 may be characterized by a second data rate. The second data rate may be greater than the first data rate. In some cases, a ratio of the second data rate to the first data rate is greater than 5:1.

In certain embodiments, semiconductor device 100 further includes a controller 112. For instance, the term "controller" refers to a digital circuit that manages the flow of data going to and from the memory device (e.g., memory device 118). Depending on the implementation, the controller can be integrated into the memory device itself or be implemented as a separate chip. The memory controller is responsible for managing the interface between the memory device and other components of semiconductor device 100 (e.g., circuit 106). As an example, circuit 110 includes controller 112, which is configured to manage a data flow between memory device 118 and circuit 106.

It is to be appreciated that circuit 110's ability to accommodate one or more interfaces characterized by different data rates provides several benefits. This dynamic adaptability ensures that while one interface is meticulously refined to cater to the rigorous data transmission and computational demands of an ultra-fast chip (e.g., circuit 106), another can be harmonized to be in sync with a component (e.g., memory device 118) that necessitates lower data rates. Furthermore, by incorporating interfaces optimized for elevated data rates, circuit 110 effectively breaks the spatial constraints on circuit 106 and memory device 118. Additionally, this configuration allows the semiconductor device 100 to effectively manage extended routing lengths while ensuring signal integrity. This ability provides unprecedented flexibility in chip layout such that various components (e.g., circuit 106 and memory device 118) are no longer bound by physical proximities and can be positioned to optimize other factors like heat dissipation or component interplay.

In some embodiments, the connections among components of semiconductor device 100 may be established through an interposer 104, which can serve as a bridging substrate to ensure high-fidelity data exchange across semiconductor device 100. The term "interposer" may refer to an electrical interface that redirects electrical connections between electrical components, which can spread a connection to a wider pitch or reroute a connection to a different connection. For instance, interposer 104 may include a substrate that facilitates electrical connections among multiple components using one or more interconnects, allowing for high-speed data transfer and compact semiconductor integration. As an example, circuit 106 and/or circuit 110 may be coupled to interposer 104. Memory device 118 may be coupled to interposer 104. Connections among circuit 106, circuit 110, and memory device 118 may be established through interposer 104 using one or more interconnects.

In some embodiments, semiconductor device 100 further includes a substrate 102 coupled to interposer 104. As an example, substrate 102 may serve as the base material for mounting and/or interconnecting the active and passive components, such as transistors, diodes, interposers, and integrated circuits. For example, substrate 102 may be made of a material that is an insulator or a low-resistivity conductor, such as ceramic, silicon, or fiberglass.

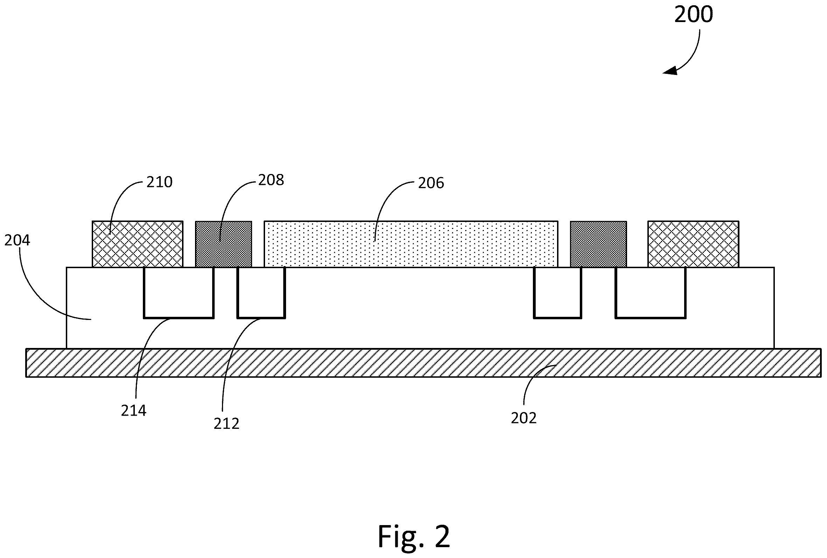

Figure 2 is a simplified diagram illustrating a cross-section view of a semiconductor device 200 characterized by an integration scheme according to embodiments of the subject technology. This diagram is merely an example, which should not unduly limit the scope of the claims. One of ordinary skill in the art would recognize many variations, alternatives, and modifications.

Semiconductor device 200 as illustrated in Figure 2, includes a substrate 202, an interposer 204, a circuit 206, a circuit 208, and a memory device 210. In some embodiments, circuit 208 (e.g., a second circuit recited in claim 1) may be coupled to circuit 206 (e.g., a first circuit recited in claim 1). For instance, circuit 206 can include an application-specific integrated circuit (ASIC), a central processing unit (CPU), memory interfaces, input/output devices, input/output interfaces, secondary storage interfaces, and/or the like. Interposer 204 may be coupled to circuit 208 and/or circuit 206. Memory device 210 (e.g., a first memory device recited in claim 1) may be coupled to interposer 204. Substrate 202 may be coupled to interposer 204. Interposer 204 may include a substrate that facilitates electrical connections among multiple components using one or more interconnects, allowing for high-speed data transfer and compact semiconductor integration. Substrate 202 may serve as the base material for mounting and/or interconnecting the active and passive components, such as transistors, diodes, interposers, and integrated circuits. Circuit 208 may be configured to bridge the connections between circuit 206 and memory device 210, ensuring smooth and efficient data communication.

As previously noted, interposer 204 may be configured to provide electrical connections for components of semiconductor device 200. In various implementations, interposer 204 includes an interconnect 212 (e.g., a first interconnected recited in the claims) and an interconnect 214 (e.g., a second interconnected recited in the claims). Circuit 206 may be coupled to circuit 208 through interconnect 212. For instance, an interface of circuit 206 (e.g., interface 108 of Figure 1) is coupled to an interface of circuit 208 (e.g., interface 120 of Figure 1) through interconnect 212. Memory device 210 may be coupled to circuit 208 through interconnect 214. For example, an interface of memory device 210 (e.g., interface 116 of Figure 1) may be coupled to an interface of circuit 208 (e.g., interface 114 of Figure 1). Interconnect 212 and interconnect 214 may include, without limitation, metal traces, vias, and/or other conductive materials and structures. The term "interconnect" may refer to an electrical structure that establishes electrical pathways between different components or sections of the semiconductor device, allowing for data, signal, and/or power transmission. The interfaces that support high data rates (e.g., greater than 256 Gbps) can manage extended routing lengths, which allows for unparalleled spatial freedom and rapid data exchange, thereby improving the overall system performance and design flexibility.

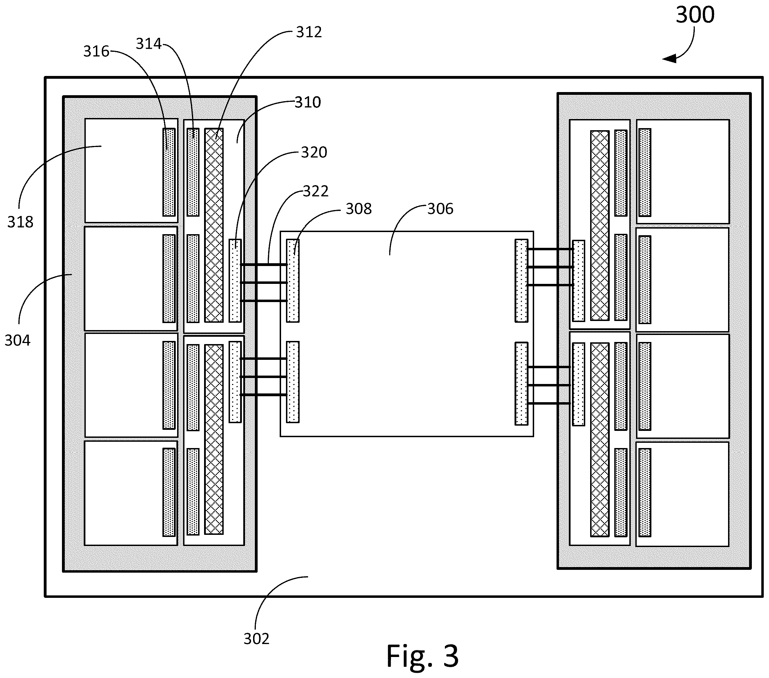

Figure 3 is a simplified diagram illustrating a semiconductor device 300 characterized by an integration scheme according to embodiments of the subject technology. This diagram is merely an example, which should not unduly limit the scope of the claims. One of ordinary skill in the art would recognize many variations, alternatives, and modifications.

As shown, semiconductor device 300 may include a substrate 302, an interposer 304, a circuit 306, a circuit 310, and a memory device 318. In various implementations, circuit 306 (e.g., a first circuit recited in claim 1) includes an interface 308 (e.g., a first interface recited in claim 1). Circuit 306 may include an application-specific integrated circuit (ASIC), a central processing unit (CPU), memory interfaces, input/output devices, input/output interfaces, secondary storage interfaces, and/or the like. Interface 308 may be a physical interface and/or logic interface based upon various industry standards including, without limitation, Double Data Rate (DDR), High Bandwidth Memory (HBM), Hybrid Memory Cube (HMC), Serial Memory Interface (SMI), Coherent Accelerator Processor Interface (CAPI), and/or the like. For instance, interface 308 includes a die-to-die interface, which may be configured to connect and interact with other components of semiconductor 300.

In some embodiments, semiconductor device 300 may further include a memory device 318 (e.g., a first memory device recited in claim 1). For instance, memory device 318 includes, without limitation, high-bandwidth memory (HBM), Dynamic random-access memory (DRAM), static random-access memory (SRAM), flash memory, phase-change memory (PCM), magnetoresistive rand random-access memory (MRAM), electrically erasable programmable read-only memory (EEPROM), and/or the like. In various examples, memory device 318 may include an interface 316 (e.g., a fourth interface recited in claim 1), which may be configured to connect and interact with other components of semiconductor 300. Interface 316 may include, without limitation, Double Data Rate (DDR), High Bandwidth Memory (HBM), Hybrid Memory Cube (HMC), Serial Memory Interface (SMI), Coherent Accelerator Processor Interface (CAPI), and/or the like. As an example, interface 316 includes an HBM interface.

In various implementations, memory device 318 can be coupled to circuit 306 through circuit 310 (e.g., a second circuit recited in claim 1). Circuit 310 may be configured to bridge the connections between circuit 306 and memory device 318, ensuring smooth and efficient data communication. Its architecture can be tailored to adeptly translate, route, and buffer data transmissions, facilitating synchronous communication between the components. This is important when the involved components, such as circuit 306 and memory device 318, are designed to function based on distinct operational speeds or set industry standards.

As an example, circuit 310 includes an interface 320 (e.g., a third interface recited in claim 1) and an interface 314 (e.g., a second interface recited in claim 1). Interface 320 may be coupled to interface 308 of circuit 306. Interface 314 may be coupled to interface 316 of memory device 318. These interfaces enable bi-directional data transmission and can be equipped with advanced capabilities including, without limitation, error mitigation, signal conditioning, and/or synchronization features. Depending on the implementation, these interfaces may be characterized by different data rates. For instance, interface 316 and interface 314 may be characterized by a first data rate; interface 308 and interface 320 may be characterized by a second data rate. The second data rate may be greater than the first data rate. In some cases, a ratio of the second data rate to the first data rate is greater than 5:1, or even higher.

Depending on the implementation, interposer 304 and substrate 302 can both be configured to establish connections across semiconductor 302. Interposer 304 may include a substrate that facilitates electrical connections among multiple components using one or more interconnects, allowing for high-speed data transfer and compact semiconductor integration. Substrate 302 may serve as the base material for mounting and/or interconnecting the active and passive components, such as transistors, diodes, interposers, and integrated circuits. For example, substrate 302 may be made of a material that is an insulator or a low-resistivity conductor, such as ceramic, silicon, or fiberglass. As an example, circuit 306 may be coupled to substrate 302. Circuit 310 may be coupled to interposer 304. Memory device 318 may be coupled to interposer 304. In some cases, interface 320 may be extended to drive over substrate 302. For example, interface 320 may be coupled to interface 308 through an interconnect 322. Interconnect 322 may be configured to transmit data between the components (e.g., circuit 306 and circuit 308). For instance, interconnect 322 includes, without limitation, wires, cables, connectors, and/or the like.

In certain embodiments, semiconductor device 300 further includes a controller 312. The controller can be configured to manage the interface between the memory device (e.g., memory device 318) and other components of semiconductor device 300 (e.g., circuit 306). Depending on the implementation, the controller can be integrated into the memory device itself or be implemented as a separate chip. As an example, circuit 310 includes controller 312, which is configured to manage a data flow between memory device 318 and circuit 306.

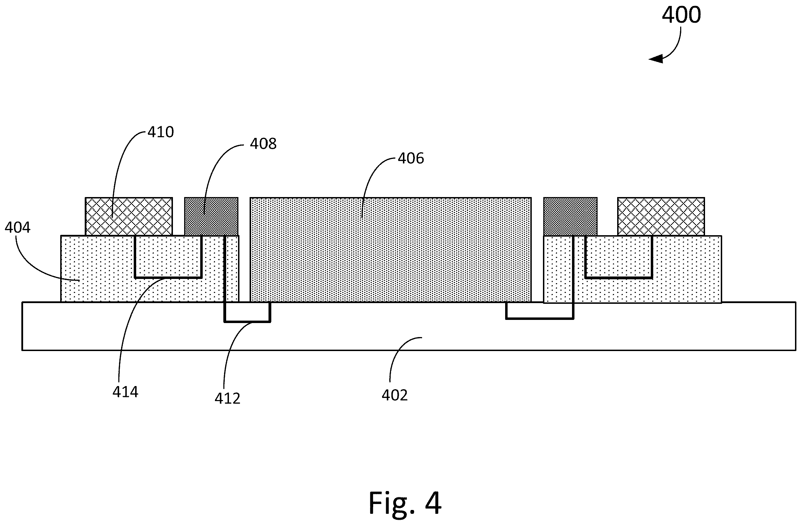

Figure 4 is a simplified diagram illustrating a semiconductor device 400 characterized by an integration scheme according to embodiments of the subject technology. This diagram is merely an example, which should not unduly limit the scope of the claims. One of ordinary skill in the art would recognize many variations, alternatives, and modifications.

Semiconductor device 400 as illustrated in Figure 4, includes a substrate 402, an interposer 404, a circuit 406, a circuit 408, and a memory device 410. For instance, circuit 406 can include an application-specific integrated circuit (ASIC), a central processing unit (CPU), memory interfaces, input/output devices, input/output interfaces, secondary storage interfaces, and/or the like. In some embodiments, circuit 408 may be coupled to circuit 406 through an interconnect 412. Circuit 408 may be coupled to memory device 410 through an interconnect 414. For instance, interconnect 412 and interconnect 414 may include, without limitation, metal traces, vias, and/or other conductive materials and structures.

In various implementations, substrate 402 may be coupled to interposer 404. Interposer 404 may include a substrate that facilitates electrical connections among multiple components using one or more interconnects, allowing for high-speed data transfer and compact semiconductor integration. Substrate 402 may serve as the base material for mounting and/or interconnecting the active and passive components, such as transistors, diodes, interposers, and integrated circuits. In some embodiments, circuit 406 may be coupled to substrate 402. Interposer 404 may be coupled to circuit 408 and memory device 410. The interface of circuit 408 (e.g., interface 320 of Figure 3) may be extended to drive over substrate 402. It is to be appreciated that the direct coupling between circuit 406 and substrate 402 effectively reduces the spatial footprint of interposer 404, leading to a direct reduction in production costs, particularly beneficial for large-scale manufacturing. Moreover, the compact design provides enhanced layout flexibility, potentially allowing for the integration of additional components or enabling modifications, contributing to optimal thermal management and overall system efficiency.

While the above is a full description of the specific embodiments, various modifications, alternative constructions and equivalents may be used. Therefore, the above description and illustrations should not be taken as limiting the scope of the subject technology which is defined by the appended claims.

## Claims

1. An apparatus, comprising:
a first circuit (106, 206, 306) comprising a first interface (108, 308);
a second circuit (110, 208, 310) coupled to the first circuit (106, 206, 306), the second circuit (110, 208, 310) comprising a second interface (114, 314) and a third interface (120, 320), the third interface (120, 320) being coupled to the first interface (108, 308);
an interposer (104, 204, 304, 404) coupled to the second circuit (110, 208, 310); and
a first memory device (118, 210, 318) coupled to the interposer (104, 204, 304, 404), the first memory device (118, 210, 318) comprising a fourth interface (116, 316), the fourth interface (116, 316) being coupled to the second interface (114, 314);
wherein the second interface (114, 314) is **characterized by** a first data rate, the third interface (120, 320) is **characterized by** a second data rate, and the second data rate is greater than the first data rate.

2. The apparatus of claim 1, further comprising a substrate (102, 202, 302, 402) coupled to the interposer (104, 204, 304, 404).

3. The apparatus of claim 1 or 2, wherein the first circuit (106, 206, 306) is coupled to the substrate (102, 202, 302, 402).

4. The apparatus of any of claims 1 to 3, wherein the interposer (104, 204, 304, 404) comprises a first interconnect (212), and the first interface (108, 308) is coupled to the third interface (120, 320) through the first interconnect (212).

5. The apparatus of any of claims 1 to 4, wherein the interposer (104, 204, 304, 404) comprises a second interconnect (214), and the second interface (114, 314) is coupled to the fourth interface (116, 316) through the second interconnect (214).

6. The apparatus of any of claims 1 to 5, wherein the second circuit (110, 208, 310) further comprises a controller (112, 312) configured to manage a data flow between the first memory device (118, 210, 318) and the first circuit (106, 206, 306).

7. The apparatus of any of claims 1 to 6, wherein the first memory device (118, 210, 318) further comprises a high-bandwidth memory.

8. The apparatus of any of claims 1 to 7, wherein a ratio of the second data rate to the first data rate is greater than 5:1.

9. An apparatus, comprising:
a substrate (102, 202, 302, 402);
an interposer (104, 204, 304, 404) coupled to the substrate (102, 202, 302, 402);
a first circuit (106, 206, 306) coupled to the interposer (104, 204, 304, 404), the first circuit (106, 206, 306) comprising a first interface (108, 308);
a second circuit (110, 208, 310) coupled to the interposer (104, 204, 304, 404), the second circuit (110, 208, 310) comprising a second interface (114, 314) and a third interface (120, 320), the third interface (120, 320) being coupled to the first interface (108, 308); and
a first memory device (118, 210, 318) coupled to the interposer (104, 204, 304, 404), the first memory device (118, 210, 318) comprising a fourth interface (116, 316), the fourth interface (116, 316) being coupled to the second interface (114, 314);
wherein the second interface (114, 314) is **characterized by** a first data rate, the third interface (120, 320) is **characterized by** a second data rate, and the second data rate is greater than the first data rate.

10. The apparatus of claim 9, comprising at least one of the following features:
wherein the interposer (104, 204, 304, 404) comprises a first interconnect (212), and the first interface (108, 308) is coupled to the third interface (120, 320) through the first interconnect (212);
wherein the interposer (104, 204, 304, 404) comprises a second interconnect (214), and the second interface (114, 314) is coupled to the fourth interface (116, 316) through the second interconnect (214);
wherein the second circuit (110, 208, 310) further comprises a controller (112, 312) configured to manage a data flow between the first memory device (118, 210, 318) and the first circuit (106, 206, 306);
wherein the first memory device (118, 210, 318) further comprises a high-bandwidth memory;
wherein a ratio of the second data rate to the first data rate is greater than 5:1.

11. An apparatus, comprising:
a substrate (102, 202, 302, 402);
a first circuit (106, 206, 306) coupled to the substrate (102, 202, 302, 402), the first circuit (106, 206, 306) comprising a first interface (108, 308);
a second circuit (110, 208, 310) coupled to the first circuit (106, 206, 306), the second circuit (110, 208, 310) comprising a second interface (114, 314) and a third interface (120, 320), the third interface (120, 320) being coupled to the first interface (108, 308); and
a first memory device (118, 210, 318) coupled to the second circuit (110, 208, 310), the first memory device (118, 210, 318) comprising a fourth interface (116, 316), the fourth interface (116, 316) being coupled to the second interface (114, 314);
wherein the second interface (114, 314) is **characterized by** a first data rate, the third interface (120, 320) is **characterized by** a second data rate, and the second data rate is greater than the first data rate.

12. The apparatus of claim 11, further comprising an interposer (104, 204, 304, 404) coupled between the substrate (102, 202, 302, 402) and the second circuit (110, 208, 310).

13. The apparatus of claim 11 or 12, further comprising a second memory device (122), the second memory device (122) coupled to the second circuit (110, 208, 310).

14. The apparatus of claim 13, wherein the second circuit (110, 208, 310) further comprises a fifth interface (126), and the second memory device (122) comprises a sixth interface (124) coupled to the fifth interface (126).

15. The apparatus of any of claims 11 to 14, comprising at least one of the following features:
wherein the second circuit (110, 208, 310) comprises a controller (112, 312) configured to manage a data flow between the first memory device (118, 210, 318) and the first circuit (106, 206, 306);
wherein a ratio of the second data rate to the first data rate is greater than 5:1.
